# EUROPEAN PATENT APPLICATION

(11) **EP 1 321 977 A1**
(43) Date of publication of application: **25.06.2003**
(21) Application number: 01403276.7
(22) Date of filing: 17.12.2001
(51) Int. Cl.: H01L 21/3213

(54) **Method for reducing residual electric charge created by a previous process step on a conductive structure**

(71) Applicant: AMI Semiconductor Belgium BVBA, 9700 Oudenaarde (BE)
(72) Inventor: Bruneel, Pierre Stefaan, 9000 Gent (BE); De Backer, Eddy, 9820 Merelbeke (BE); Fathoutdinov, Malik Masgutovich, 9700 Oudenaarde (BE)
(74) Representative: Bird, William Edward

(57) **Abstract**

Method for reducing a residual electric charge created by a previous process step, particularly a plasma treatment, on a conductive structure, particularly in a semiconductor integrated circuit, is characterised in that the conductive structure is submitted to a plasma treatment having a discharging effect. This discharging treatment can be performed as a stand alone step with selected gas composition of the plasma and/or other parameters adapted like applied power and process pressure, or may be done at the end of the former plasma treatment by altering the gas composition of the plasma and/or other parameters like applied power and process pressure.

## Description

The invention relates to a method for reducing a residual electric charge created by a previous process step, particularly a plasma treatment, on a conductive structure, particularly in a semiconductor integrated circuit.

The manufacturing of a semiconductor integrated circuit comprises plasma treatments, for instance the plasma etching of conductive layers such as interconnects, or the plasma removal of an organic mask used for patterning a conductive layer.

As is well known, such plasma treatments might cause conductive layers to be electrically charged. Charges of the conductive layers should be avoided as they can negatively influence the lifetime of the integrated circuit.

Therefore, after plasma treatment, the wafer is subjected to an additional step to remove or neutralise the residual charges on the conductive structures.

According to US patent No. 6.077.762 the electric charge of the metallisation layer built-up during plasma etching is neutralised by contacting this layer with a conductive liquid, particularly a liquid metal such as mercury, which is electrically grounded. However, the use of a liquid conductive metal is rather unconventional in semiconductor processing, and is complicated and expensive.

US patent No. 6.093.658 discloses a method for manufacturing a semiconductor IC, wherein the wafer is exposed to an electron dose of 5.000 µC/cm² to 25.000 µC/cm² which is configured to neutralise the electric charge that is built up in a metallisation layer patterned by plasma etching. This method, however, requires an electron beam system which is no typical system to use in the manufacturing of semiconductor IC's and which is relatively expensive.

The invention seeks to provide a simple and economic method for reducing a residual electric charge created by a previous process step on a conductive structure.

In accordance with the invention, this object is accomplished by submitting the wafer with the conductive structures to a plasma treatment having a discharging effect.

The plasma treatment may be performed as a stand alone step with selected gas composition of the plasma and/or other parameters like applied power and process pressure

If the charge has been created by a plasma treatment, the discharging treatment may be done at the end of this former plasma treatment by altering the gas composition of the plasma and/or other parameters of the plasma treatment, such as the applied power or process pressure.

A suitable gas composition for the discharging plasma treatment may contain Hydrogen, Helium, Argon or Fluorine or a mixture of two or more of these gases. Hydrogen containing gas may be Forming-gas or water vapour. When the plasma contains fluorine, the recommended source of Fluorine in the plasma is CF₄, NF₃, SF₆, CHF₃, or C₂F₆ gas.

In some cases, the discharging plasma treatment may, at least partly, constitute a step of the complete process, for example the removal of an organic mask by a plasma treatment.

Details and characteristics of the invention will appear from the following description in which reference is made to the attached drawings wherein:
Figure 1 shows schematically a portion of a section of an integrated circuit;
Figure 2 is a block diagram of the last steps of the method for manufacturing the semiconductor device of figure 1, comprising the reduction of residual electric charges according to the invention;
Figure 3 is a block diagram similar to the one of Figure 2, but pertaining to another form of embodiment of the invention;
Figure 4 shows a portion of a section of an integrated circuit similar to the one of figure 1, but pertaining to another form of embodiment, manufactured with application of the method of the invention.

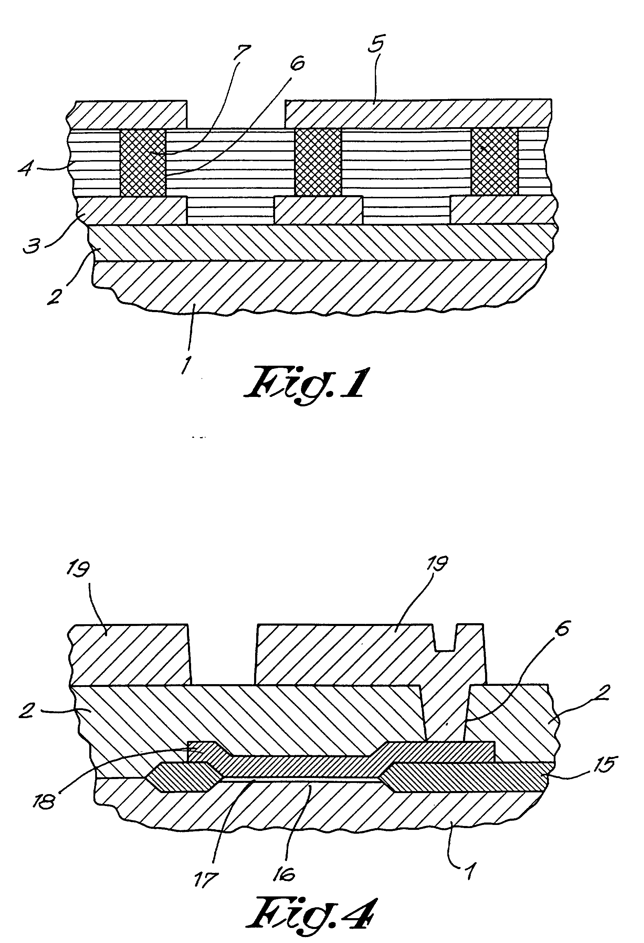

The subject invention has as purpose to neutralize charges that are built up during previous plasma treatment of layers during the manufacturing of an integrated circuit. A first example will be described with reference to figure 1, wherein the plasma treatment deals with the top metal layer 5.

Figure 1 further shows a patterned conductive layer 3 created on an insulating layer 2, for instance of silicon dioxide.

This conductive layer 3 is a layer of metal interconnects or interconnects of amorphous or polycrystalline silicon.

The insulating layer 2 is for example created on a substrate 1 of silicon whereon Integrated Circuit devices (not shown) are created. The conductive layer 3, e.g. a Al/Cu metallisation layer, is formed over the layer 2.

A following insulating dielectric layer 4 is deposited on the conductive layer 3 and the dielectric layer 2. This following dielectric layer 4 may be planarised using for instance a conventional Chemical Mechanical Polishing technique.

A second interconnect layer, this is the metallisation layer 5, is created above the dielectric layer 4, but to interconnect both layers 3 and 5, holes 6 are formed in the dielectric layer 4 and filled with tungsten to form tungsten plugs 7 before the metallisation layer 5 is deposited.

The via holes 6 are made by standard photolitography and etching.

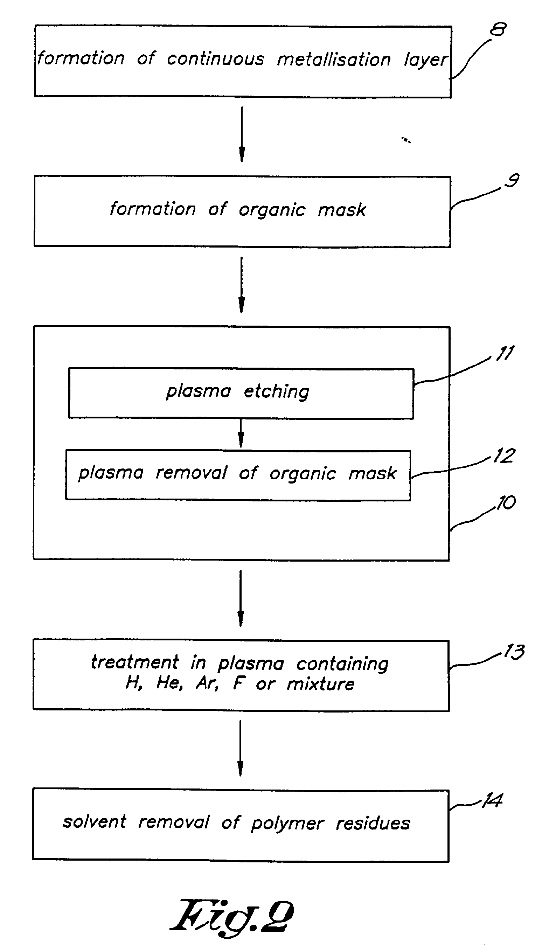

The patterned metallisation layer 5 is formed as shown in the block diagram of figure 2.

In a first operation 8, a continuous metallisation layer, for instance from W, Al/Cu or Al/Si/Cu is deposited, for instance sputtered, on the complete wafer surface
The continuous metallisation layer is then patterned using conventional photolithography and plasma etching techniques. In the operation 9 of photolithography, a photoresist organic mask is formed on top of the metallisation layer by forming a photoresist layer on this metallisation layer, selectively exposing the photoresist to light of short wavelenght through a patterned reticle and developing the photoresist.

Once the mask is formed, the obtained wafer is introduced in a plasma etcher wherein successively are performed a plasma etching operation 11 on the metal wherein the exposed parts of the metallisation layer are etched away, and a stripping operation 12 wherein the mask is removed in situ. The fact that both operations 11 and 12 are performed in the same equipment is denoted by block 10 around both operations 11 and 12 as is shown in figure 2.

The patterned metallisation layer 5 as well as the first mentioned conductive layer 3 are not always electrically connected to the substrate 1. Consequently, these layers and the tungsten plugs will be electrically charged by the plasma etching operations 11 and 12.

In order to reduce these residual electrical charges in these conductive structures due to the plasma etching of the metallisation layer, the wafer is transferred to an ex-situ plasma module wherein the wafer is subjected to an operation 13, i.e. a treatment with a plasma containing Fluorine, Hydrogen, Argon, Helium or a mixture of two or more of these gases.

As source of Fluorine in the plasma gases as CF₄, NF₃, SF₆, CHF₃, or C₂F₆ are recommended.

As source of Hydrogen in the plasma, Forming-gas (a mixture of H₂ and N₂) or water vapour (H₂O) is recommended.

Oxygen or Oxygen containing gas may be added to the plasma. Oxygen and Oxygen containing additives may facilitate the removal of the organic mask.

After the supplemental plasma treatment, a cleaning operation 14 is accomplished which consists of immersing the obtained wafer in a solvent to remove any polymer residues produced during the plasma etching.

The formation of the patterned metallisation layer 5 according to the invention will be further illustrated by the following practical examples referring to figures 1 and 2:

### Example 1:

On the dielectric layer 4 and on the tungsten plugs 7 formed as described with reference to figure 1, an Al/Cu metallisation layer is sputtered (operation 8), and an i-line photoresist mask is formed using conventional photolithography (operation 9). This metallisation layer is plasma etched (operation 11) and the photoresist mask is plasma stripped in-situ using cluster P-5000 tool including a MxP etch chamber and a downstream strip chamber of Applied Materials (operation 12).

Then the substrate is treated in a GaSonics L3300 plasma etch system (operation 13). The parameters of the plasma treatment 13 are as follows:

| | |
|---|---|
| Pressure | 700 m Torr (0,0933 kPa) |
| RF Power | 600 W |
| Forming-gas* flow rate | 950 sccm (standard cm³) |
| N₂O flow rate | 10 sccm |
| Platen temperature | 250°C |
| Process time | 20 sec |

| | |
|---|---|
| *Forming gas is a mixture of Nitrogen with 4% of Hydrogen. | |

If the metallisation layer 5 has received an electric charge, for instance during the plasma steps (operations 11 and 12), the last mentioned plasma treatment (operation 13) removes this charge.

Once the plasma treatment is complete, the substrate is moved to a Semitool spray cleaning station for removal of residual polymers in EKC265 solvent (operation 14).

### Example 2:

Example 1 is repeated but the plasma treatment (operation 13) is performed in a Lam 4520XL plasma etch system and with the following parameters:

| | |
|---|---|
| Pressure | 450 m Torr (0,0600 kPa) |
| RF Power top | 200 W |
| RF Power bottom | 200 W |
| CF₄ flow rate | 10 sccm |
| O₂ flow rate | 400 sccm |
| Electrode temperature | 40°C/20°C (Top/Bottom) |
| He pressure | 15 Torr (2,0000 kPa) |
| Process time | 20 sec |

### Example 3:

Example 2 is repeated but the plasma treatment in a Lam 4520XL plasma etch system (operation 13) is performed with the following parameters:

| | |
|---|---|
| Pressure | 200 m Torr (0,02667 kPa) |
| RF Power top | 200 W |
| RF Power bottom | 200 W |
| Ar flow rate | 250 sccm |
| Electrode temperature | 40°C/20°C (Top/Bottom) |
| He pressure | 15 Torr (2,0000 kPa) |
| Process time | 20 sec |

### Example 4:

Example 3 is repeated but the plasma treatment (operation 13) is performed in an isotropic etch module of Lam 4500i plasma etch system and with the following parameters:

| | |
|---|---|
| Pressure | 1000 m Torr (0,1333 kPa) |
| RF Power | 600 W |
| He flow rate | 200 sccm |
| Paddle temperature | 100°C |
| Process time | 20 sec |

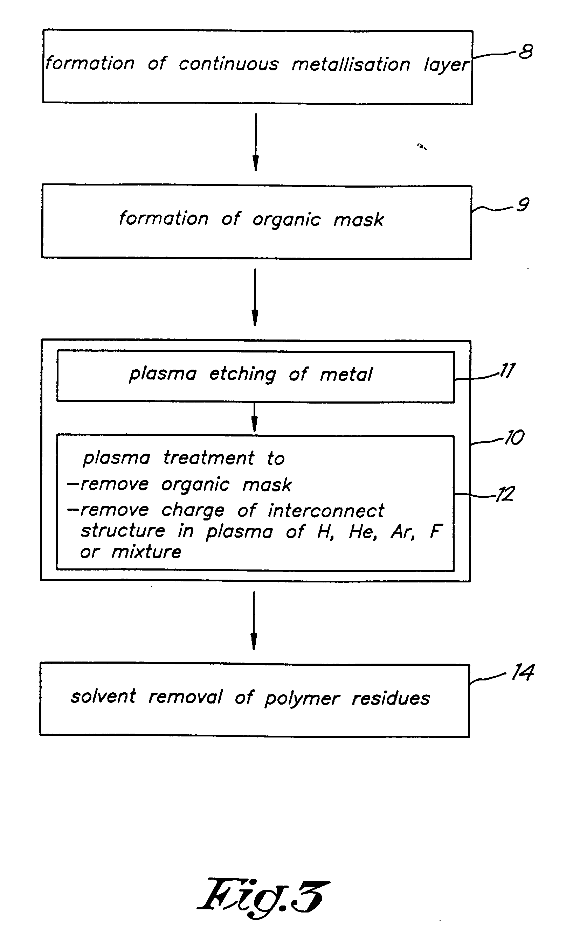

In another variant of the invention, the patterned metallisation layer 5 is obtained as shown in the diagram of figure 3.

The method differs from the above embodiment as shown in figure 2 in that the treatment with plasma containing F, H or a mixture of F and H (operation 13) is not performed ex-situ, but in-situ, this is in the same equipment used for etching the metal and for stripping the resist.

Consequently, the removal of the mask and the removal of the electrical charge from layer 5 are further combined to a single plasma treatment operation 12.
The fact that all operations 11 and 12 are done in the same plasma etch equipment is depicted by the box 10 around the two boxes which respectively depict operation 11, the etching of the metal, and operation 12, the single plasma treatment to combine the stripping of the resist and the treatment for neutralising the charge.

The following practical example will illustrate this embodiment, with reference to figures 1 and 3:

### Example 5:

On the dielectric layer 4 and tungsten plugs 7 formed as described with reference to figure 1, an Al/Cu metallisation layer is sputtered (operation 8), and an i-line photoresist mask is formed using conventional photolithography (operation 9). This metallisation layer is plasma etched (operation 11) using a MxP etch chamber mounted on a P-5000 cluster tool of Applied Materials.

The photoresist mask is then stripped in a plasma using a downstream strip chamber mounted on the same P-5000 cluster unit. This stripping process is performed in three phases each with different parameters.

The first phase is used for removing the Chlorine-containing residues of the mask to prevent further corrosion of the Al/Cu layer 5. The second phase is the main resist strip step. The third phase, which is relatively short compared to said previous phases, has the function of the plasma treatment 13 of the embodiment of figure 2, this is mainly to remove or reduce the electric charge built up during the second phase.

The parameters of this stripping are:

| | Phase 1 | Phase 2 | Phase 3 |
|---|---|---|---|
| Pressure in Torr (kPa) | 2(0,2666) | 2(0,2666) | 2(0,2666) |
| RF Power in W | 1000 | 1000 | 1000 |
| O₂ flow rate in sccm | 0 | 3000 | 0 |
| N₂ flow rate in sccm | 0 | 200 | 0 |
| H₂O flow rate in sccm | 500 | 0 | 500 |
| Platen temperature °C | 250 | 250 | 250 |
| Process time in sec. | 60 | 90 | 10 |

Once the plasma treatment is complete, the substrate is moved to a Semitool spray cleaning station for removal of residual polymers in EKC265 solvent (operation 14).

### Example 6:

Figure 4 shows another example of an integrated circuit which is manufactured as follows (with reference to figures 3 and 4):

Integrated Circuit(IC) MOS transistor devices are created on a Silicon substrate 1. This includes at least a formation of field oxide insulation areas 15 and free of field oxide active areas 16, a formation of thin gate oxide 17 on top of field oxide active areas 16, a deposition and patterning of polysilicon-gates 18 of the MOS transistors and a formation of source/drain areas of the transistors.

A silicon oxide dielectric layer 2 is deposited over the devices that are formed on the substrate 1, and via holes 6 are formed through the dielectric layer 2 to the gates 18 and active areas 16 below.

A tungsten interconnect layer 19 is deposited then (operation 8), and an i-line photoresist mask is formed using conventional photolithography (operation 9). The tungsten layer 19 is plasma etched using MxP etch chamber mounted on a P-5000 cluster tool of Applied Materials (operation 11), and the photoresist mask is stripped in plasma using a downstream strip chamber mounted on the same P-5000 cluster unit. The parameters of the resist strip process (operation 12) are :

| | Phase 1 | Phase 2 |
|---|---|---|
| Pressure, Torr (kPa) | 2(0,2666) | 2(0,2666) |
| RF Power, W | 1000 | 1000 |
| O₂ flow rate, sccm | 3000 | |
| N₂ flow rate, sccm | 200 | |
| H₂O flow rate, sccm | | 500 |
| Temperature, °C | 250 | 250 |
| Process time, sec | 90 | 10 |

The last phase of the resist strip process (phase 2) is designed to remove the electrical charge built up on the conductive structures of polysilicon gates 18 and the tungsten interconnects 19 connected to them, during the main resist removal step and/or during the plasma etch of these tungsten interconnects. If the charge is not removed until the next operation, it keeps an electrical stress on the gate oxide dielectric and increases the chance of a breaking it down. That, in turn, reduces the reliability of the IC.

## Claims

1. Method for reducing a residual electric charge created by a previous process step, particularly a plasma treatment, on a conductive structure, particularly in a semiconductor integrated circuit, **characterised in that** the conductive structure is submitted to a plasma treatment having a discharging effect.

2. Method according to claim 1, **characterised in that** the plasma treatment is performed as a stand alone step with selected gas composition of the plasma and/or other parameters like applied power and process pressure.

3. Method according to claim 1, **characterised in that** when the charge has been created by a plasma treatment, the discharging treatment is done at the end of this plasma treatment by altering the gas composition of the plasma and/or other parameters of the plasma treatment such as the applied power and process pressure.

4. Method according to any one of the preceding claims, **characterised in that** the discharging plasma treatment is performed by selecting a gas for the plasma containing Hydrogen, Helium, Argon, or Fluorine or a mixture of two or more of these gases.

5. Method according to claim 4, **characterised in that** the Hydrogen containing gas may be Forming gas or water vapour.

6. Method according to claim 4, **characterised in that** the fluorine containing gas in the plasma is CF₄, NF₃, SF₆, CHF₃, or C₂F₆ gas.

7. Method according to any one of the preceding claims, **characterised in that** Oxygen or Oxygen containing gas is added to the plasma.

8. Method according to any one of the preceding claims, **characterised in that** the discharging plasma treatment at least partly constitutes a step of the complete process, for example the removal of an organic mask.
